(19) Europäisches Patentamt
European Patent Office
Office européen des brevets

(11) **EP 1 831 979 B1**

(12) **EUROPÄISCHE PATENTSCHRIFT**

(45) Veröffentlichungstag und Bekanntmachung des Hinweises auf die Patenterteilung:
**11.09.2013 Patentblatt 2013/37**

(21) Anmeldenummer: **05815729.8**

(22) Anmeldetag: **28.11.2005**

(51) Int Cl.:
*H02H 3/04* *(2006.01)*

(86) Internationale Anmeldenummer:
**PCT/EP2005/056283**

(87) Internationale Veröffentlichungsnummer:
**WO 2006/067024 (29.06.2006 Gazette 2006/26)**

(54) **SCHALTUNGSANORDNUNG UND VERFAHREN ZUM ERFASSEN DES ZUSTANDES EINES SCHALTUNGSSCHUTZELEMENTES**

CIRCUIT ARRANGEMENT AND METHOD FOR DETECTING THE STATE OF A CIRCUIT PROTECTION ELEMENT

ENSEMBLE CIRCUIT ET PROCEDE DE DETECTION DE L'ETAT D'UN ELEMENT DE PROTECTION DU CIRCUIT

(84) Benannte Vertragsstaaten:
**DE ES FR GB IT**

(30) Priorität: **22.12.2004 DE 102004061909**

(43) Veröffentlichungstag der Anmeldung:
**12.09.2007 Patentblatt 2007/37**

(73) Patentinhaber: **Nokia Siemens Networks GmbH & Co. KG**
**81541 München (DE)**

(72) Erfinder: **SIEBEN, Bernhard**
**Neuried 82061 (DE)**

(56) Entgegenhaltungen:
**DE-U1- 8 913 708    US-A1- 2004 246 644**

**Beschreibung**

Die Erfindung betrifft unter anderem eine Schaltungsanordnung mit einem Schutzelement, dessen ohmscher Widerstand vom Stromfluss durch das Schutzelement abhängt. In einem Spannungsbereich ändern sich Stromfluss durch das Schutzelement und Spannung am Schutzelement zueinander gleichläufig. In einem anderen Spannungsbereich ändern sich dagegen der Stromfluss und die Spannung zueinander gegenläufig. Mit anderen Worten hat das Schutzelement eine Kennlinie, die in einem Spannungsbereich einen positiven differentiellen Widerstand und in einem anderen Spannungsbereich einen negativen differentiellen Widerstand hat. Ein Beispiel für ein solches Schutzelement ist ein PTC-Widerstand (Positive Temperature Coefficient).

Solche Schutzelemente werden zum Schutz von Schaltungen beispielsweise gemeinsam mit Thyristoren in Teilnehmeranschlussschaltungen eingesetzt, mit deren Hilfe Endgeräte von Teilnehmern an ein Telekommunikationsnetz angeschlossen werden, insbesondere an ein durchschaltevermitteltes Telekommunikationsnetz. Wird beispielsweise die Teilnehmeranschlussschaltung auch als Prüfschaltung zum Prüfen der Teilnehmerleitung oder des Teilnehmerendgerätes verwendet, so kann das Schutzelement aufgrund seiner nicht-linearen Kennlinie die Messung verfälschen, insbesondere wenn der aktuelle Betriebszustand des Schutzelementes nicht genau bekannt ist. Ähnliche Probleme treten auch in anderen Bereichen der Technik auf, z.B. DE 8913708U1.

Es ist Aufgabe der Erfindung, eine einfach aufgebaute Schaltungsanordnung zum Erfassen des Zustandes des Schutzelementes anzugeben. Insbesondere soll die Schaltungsanordnung bei einer Vielzahl von voneinander verschiedenen Störfällen, in denen das Schutzelement die Schaltungsanordnung schützt, ein sicheres Erfassen ermöglichen. Insbesondere soll die Schaltungsanordnung weiterhin ein sicheres Erfassen ermöglichen, wenn das Erfassen des Zustandes durch eine Vielzahl von großen Toleranzen erschwert ist. Außerdem soll ein Verfahren zum Erfassen des Zustandes des Schaltungsschutzelementes angegeben werden.

Die auf die Schaltungsanordnung bezogene Aufgabe wird durch eine Schaltungsanordnung mit den in dem Patentanspruch 1 angegebenen Einheiten gelöst. Weiterbildungen sind in den Unteransprüchen angegeben.

Bei der erfindungsgemäßen Schaltungsanordnung wird der differentielle Widerstand oder das Vorzeichen des differentiellen Widerstands des Schutzelementes ermittelt, z.B. eines PTC-Widerstandes (Positive Temperature Coefficient), d.h. eines sogenannten Kaltleiters. Dadurch kann eine sichere Aussage über den Zustand des Schutzelementes getroffen werden. Ist der differentielle Widerstand des Schutzelementes positiv, so ist das Schutzelement, beispielsweise ein PTC, niederohmig. Ist dagegen der differentielle Widerstand negativ, so ist das Schutzelement hochohmig. Es ist bei dieser Vorgehensweise nicht erforderlich, den genauen Wert des differentiellen Widerstandes zu ermitteln. Dadurch ist das Verfahren robust gegenüber Erfassungstoleranzen, insbesondere robust gegenüber Messtoleranzen. Weiterhin ist die Vorgehensweise robust gegenüber Temperaturschwankungen, die den Wert des Widerstandes des Schutzelementes ebenfalls beeinflussen. Weiterhin ist das Verfahren auch robust gegenüber Schutzelementen, deren Nennwiderstandswert bei einem vorgegebenen Strom und einer vorgegebenen Temperatur stark um einem Mittelwert schwankt, beispielsweise in einem Bereich größer als +10 Prozent bis kleiner als -10 Prozent, insbesondere im Bereich von +15 Prozent bis -15 Prozent.

Die erfindungsgemäße Schaltungsanordnung enthält zusätzlich zu dem Schutzelement mindestens eine Erfassungseinheit, die mindestens ein Potential am Schutzelement oder einen durch das Schutzelement fließenden Strom erfasst. Weiterhin enthält die Schaltungsanordnung mindestens eine Vorgabeeinheit, die mindestens eine Potentialänderung am Schutzelement oder eine Änderung des Stroms durch das Schutzelement durchführt. Die Schaltungsanordnung enthält auch eine Auswerteeinheit, die eingangsseitig mit einem Ausgang der Erfassungseinheit verbunden ist und die abhängig von einem Ausgangssignal oder einem Ausgangsdatum der Erfassungseinheit und abhängig von mindestens einer mit der Vorgabeeinheit veranlassten Änderung ein Ausgangssignal oder ein Ausgangsdatum erzeugt, das eine Gleichläufigkeit oder eine Gegenläufigkeit von Spannung und Strom am Schutzelement angibt. Die Schaltungsanordnung ermöglicht ein sicheres Erfassen des Zustandes auch dann, wenn eine Stromerfassung bzw. eine Spannungserfassung nur mit einer Toleranz größer als 1 Prozent durchgeführt wird. Beispielsweise sind die absoluten Toleranzen bei der Strommessung größer als 1 Milliampere oder größer als 2 Milliampere. Die Vorgabe eines Stroms oder einer Spannung wird beispielsweise ebenfalls mit Toleranzen größer als 1 Prozent oder sogar größer als 2 Prozent durchgeführt. Beispielsweise liegen die absoluten Toleranzen bei einer Spannungsvorgabe im Bereich von bis zu 2 Volt. Auch Umgebungstemperaturschwankungen in einem Bereich von 15 Grad Celsius bis 25 Grad Celsius bzw. sogar in einem Bereich von 25 Grad Celsius bis 80 Grad Celsius beeinflussen die Erfassungssicherheit der Schaltungsanordnung nicht.

Die erfindungsgemäße Schaltungsanordnung ermöglicht es insbesondere, im Fall einer Fremdspannung an dem Teilnehmeranschluss von einer Teilnehmeranschlussschaltung aus auch eine Strommessung durchzuführen, um die Stromtragfähigkeit der Fremdspannungsquelle und damit deren Gefährlichkeit für Personen beurteilen zu können. Ist das Schutzelement hochohmig, weil die Quelle einen Strom lieferte, der oberhalb des sogenannten Kippstromes des Schutzelementes liegt, reduziert das Schutzelement den mit Hilfe des Anschlussports bzw. der Anschlussschaltung messbaren Strom unter Umständen um mehrere Größenordnungen. Da sicher festgestellt werden kann, dass das Schutzelement hochohmig ist, kann der gemessene Stromwert nach oben korrigiert werden, so dass sichere Aussagen über die Gefährlichkeit der Fremdspannungsquelle möglich sind. Damit werden besondere Maßnahmen zum Schutz von Personen nur dann veranlasst, wenn sie tatsächlich erforderlich sind. Sogenannte "Fehlalarme" treten nur noch äußerst selten oder nicht mehr auf.

Bei einer Weiterbildung der erfindungsgemäßen Schaltungsanordnung enthält die Schaltungsanordnung eine Leitung oder eine Anschlusseinheit für eine Leitung, die eine Länge von mehr als 50 Meter oder von mehr als 500 Meter hat. Insbesondere enthält die Schaltungsanordnung eine Leitung, an die auch ein Teilnehmerendgerät eines Telekommunikationsnetzes angeschlossen ist. Die Anschlusseinheit ist beispielsweise ein Stecker, eine Buchse, ein Lötstift oder ein Teil einer Klemmverbindung. Teilnehmeranschlussleitungen sind aufgrund ihrer Länge Fremdspannungseinflüssen ausgesetzt, beispielsweise bei einem Kontakt zu parallel gelegten Leitungen eines Stromversorgungsnetzes.

Bei einer nächsten Weiterbildung der erfindungsgemäßen Schaltungsanordnung enthält die Erfassungseinheit einen Leitungstreiber oder einen Teil eines Leitungstreibers. Der Leitungstreiber enthält insbesondere eine Gegentaktendstufe bzw. ermöglicht eine Spannungsverstärkung größer als 10. Leitungstreiber haben geringe Ausgangswiderstände, die insbesondere kleiner als 100 Ohm sind und damit den verlustarmen Anschluss an eine Leitung ermöglichen.

Bei einer anderen Weiterbildung der Schaltungsanordnung enthält auch die Vorgabeeinheit einen Leitungstreiber bzw. einen Teil eines Leitungstreibers. Durch diese Maßnahme wird der Leitungstreiber mehrfach genutzt, so dass der Aufwand für die Schaltungsanordnung gering ist.

Bei einer nächsten Weiterbildung veranlasst die Vorgabeeinheit mindestens zwei Änderungen. Obwohl eine Änderung zum Erfassen des Zustands des Schutzelements ausreichend wäre, gibt es bei zwei Änderungen die Möglichkeit, die Erfassungsgenauigkeit bei geeigneter Wahl der Vorgaben zu erhöhen. Beispielsweise werden zwei Gleichspannungen mit voneinander verschiedenen Vorzeichen gewählt. Ebenso lassen sich Ströme mit verschiedenen Vorzeichen einspeisen. An Stelle einer Gleichspannung bzw. eines Gleichstroms lässt sich aber auch eine Wechselspannung bzw. ein Wechselstrom verwenden. In diesem Fall lässt sich bspw. mit Hilfe eines Multiplizierers auf einfache Art und Weise die Phasenlage zwischen Strom und Spannung und damit das Vorzeichen des differentiellen Widerstandes ermitteln.

Bei einer nächsten Weiterbildung der Schaltungsanordnung enthält die Schaltungsanordnung:

- eine Spannungserfassungseinheit,
- eine Stromerfassungseinheit, und
- eine Spannungsvorgabeeinheit.

Bei einer solchen Schaltungsanordnung lassen sich besonders viele bereits vorhandene Einheiten in einer Teilnehmerschaltung für das Erfassen des Zustandes des Schutzelementes nutzen. Außerdem ist über die Bestimmung des Vorzeichens des differentiellen Widerstandes hinaus auch die Bestimmung des Wertes des differentiellen Widerstandes möglich, um so die Erfassungssicherheit zu steigern.

Bei einer nächsten Weiterbildung erfasst die Spannungserfassungseinheit die Spannung an einem Anschluss des Schutzelementes gegen Masse. Durch diese Maßnahme muss nicht die Spannung über dem Schutzelement selbst erfasst werden. Außerdem lässt sich der differentielle Widerstand bzw. das Vorzeichen des differentiellen Widerstandes erfassen, ohne dass eine Gleichtaktspannung des Leitungstreibers bekannt sein muss. Bei einer anderen Weiterbildung der erfindungsgemäßen Schaltungsanordnung ist das Schutzelement ein PTC-Widerstand, ein sogenannter Polyswitch oder ein anderes Schutzelement, das die eingangs erläuterte Kennlinie hat. Die genannten Schutzelemente haben einen Widerstand, der stark temperaturabhängig ist, so dass an das sichere Erfassen des Betriebszustands des Schutzelements besonders hohe Anforderungen gestellt werden.

Bei einer nächsten Weiterbildung enthält die Schaltungsanordnung eine Steuereinheit, die ausgangsseitig mit der Vorgabeeinheit und der Auswerteeinheit verbunden ist und damit deren Arbeitsweise steuert. Die Steuereinheit enthält beispielsweise einen Prozessor, der in einem Speicher gespeicherte Programmbefehle ausführt. Bei einer Alternative enthält die Steuerschaltung dagegen keinen Prozessor.

Die Erfindung betrifft außerdem Verfahren zum Erfassen des Zustandes eines Schutzelementes, insbesondere mit der erfindungsgemäßen Schaltungsanordnung oder einer ihrer Weiterbildungen. Damit gelten die oben genannten technischen Wirkungen auch für die Verfahren. Die Verfahren lassen sich auf einfache Art und mit einer hohen Erfassungssicherheit durchführen.

Im Folgenden werden Ausführungsbeispiele der Erfindung an Hand der beiliegenden Zeichnungen erläutert. Darin zeigen:

Figur 1    eine Teilnehmeranschluss-Schaltungsanordnung,
Figur 2    eine Kennlinie eines PTCs, und
Figur 3    Verfahrensschritte zum Bestimmen des Zustandes eines PTCs.

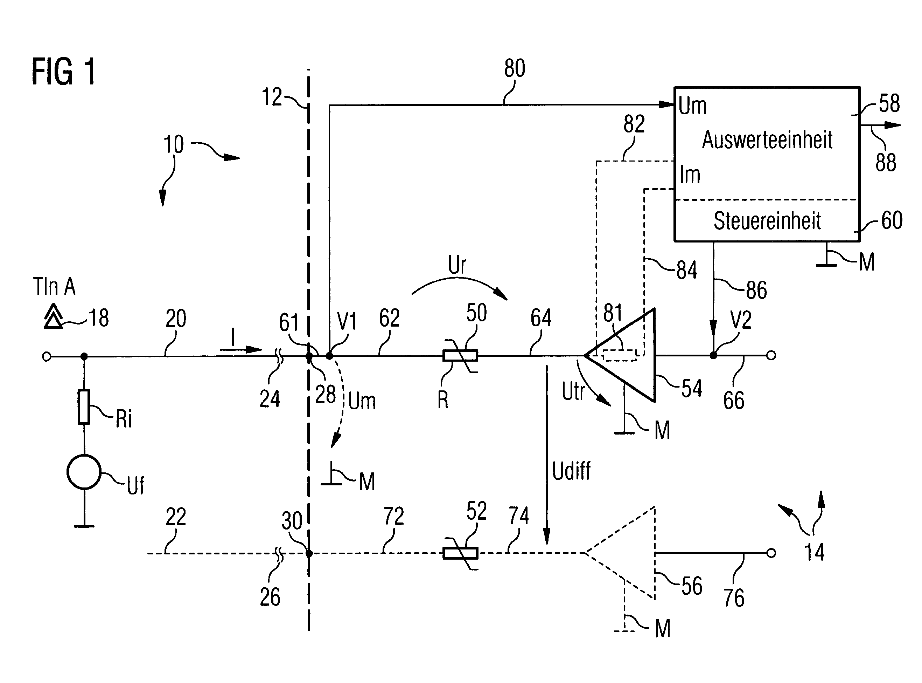

Figur 1 zeigt eine Teilnehmeranschluss-Schaltungsanordnung 10, die rechts einer vertikal verlaufenden gestrichelten Linie 12 eine netzseitige Anschlussschaltung 14 enthält, die auch als SLIC (Subscriber Line Interface Circuit) bezeichnet wird. Links der gestrichelten Linie 14 liegt eine Zweidrahtleitung, die zu einem Telefon 18 eines Teilnehmers TlnA führt.

Die Zweidrahtleitung enthält einen Draht 20 und einen Draht 22, die beispielsweise jeweils eine Länge von über 1 km haben. In einem Störfall kommt es zum Aufschalten einer Fremdspannung Uf auf den Draht 20. Eine die Fremdspannung Uf erzeugende Fremdspannungsquelle ist beispielsweise eine Wechselspannungsquelle oder eine Gleichspannungsquelle. Die Fremdspannungsquelle hat einen Innenwiderstand Ri. Wellenlinien 24, 26 deuten die stark verkürzte Darstellung der Zweidrahtleitung in Figur 1 an. Der Draht 20 ist an einen Anschluss 28 der Anschlussschaltung 14 angeschlossen. Der Draht 22 ist an einen Anschluss 30 angeschlossen. Beispielsweise sind die Anschlüsse 28 und 30 Buchsen oder Stecker einer Steckverbindung. Alternativ werden Klemm- oder Lötverbindungen eingesetzt.

Die Anschlussschaltung 14 enthält:

- zwei PTC-Widerstände 50, 52,
- zwei Leitungstreiber 54, 56,
- eine Auswerteeinheit 58,
- eine Steuereinheit 60, und
- eine Auswerteeinheit 58.

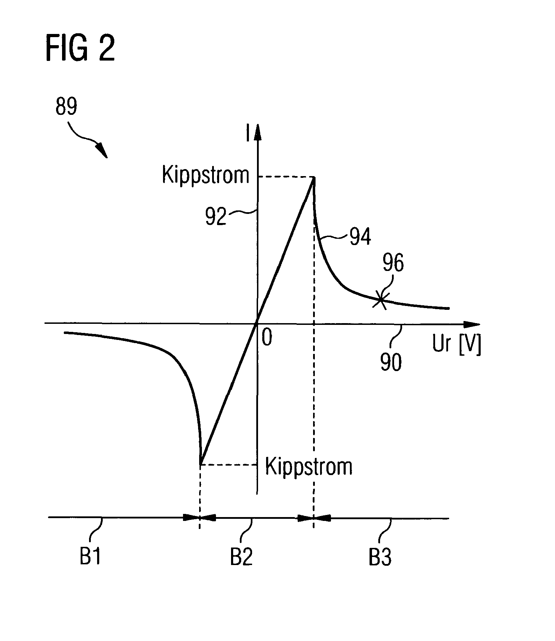

Die Kennlinien der PTC-Widerstände 50, 52 werden unten an Hand der Figur 2 näher erläutert. Die Leitungstreiber 54 und 56 sind beispielsweise Bestandteile einer Gegentaktendstufe, die zwei Ausgänge hat, zwischen denen eine Differenzspannung Udiff erzeugt wird. Vom Treiberausgang des Leitungstreibers 54 gegen Masse M liegt eine Treiberspannung Utr an.

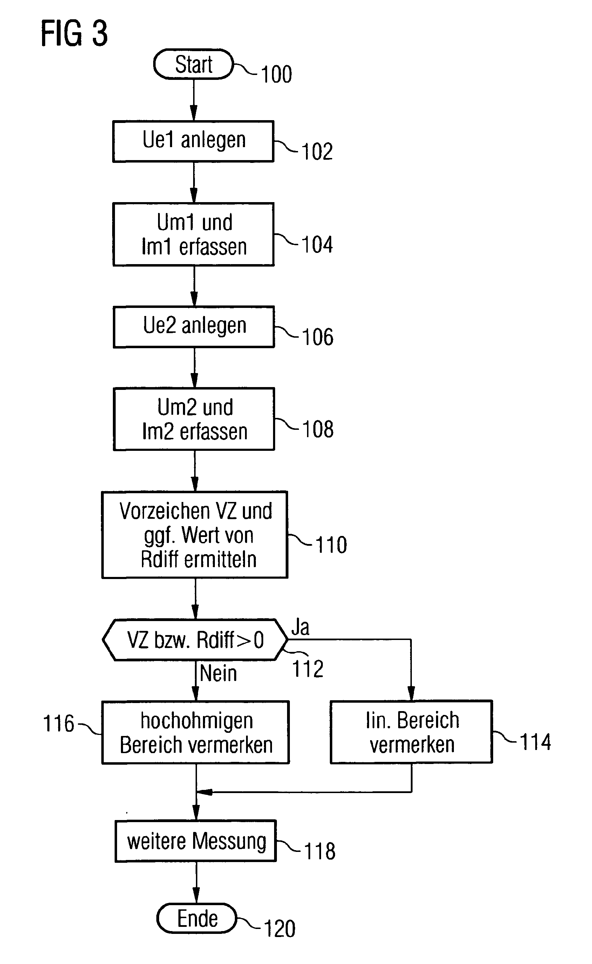

Die Funktionen der Auswerteeinheit 58 und der Steuereinheit 60 werden beispielsweise mit Hilfe eines Prozessors erbracht, wobei die Auswerteeinheit bzw. die Steuereinheit auch Analog/Digital- bzw. Digital/Analog-Wandler enthält. Die Funktionen der Auswerteeinheit 58 und der Steuereinheit 60 werden auch bei der Erläuterung der in Figur 3 dargestellten Verfahrensschritte deutlich.

Eine Verbindung 61 führt vom Anschluss 28 zu einer Verzweigung V1. Von der Verzweigung V1 führt eine elektrisch leitfähige Verbindung 62 zu dem einen Anschluss des PTC-Widerstandes 50. Eine Verbindung 64 führt von dem anderen Anschluss des PTC-Widerstandes 50 zum Ausgang des Leitungstreibers 54. Weiterhin führt eine Verbindung 72 vom Anschluss 30 zu einem Anschluss des PTC-Widerstandes 52. Eine Verbindung 74 führt vom anderen Anschluss des PTC-Widerstandes 52 zum Ausgang des Leitungstreibers 56. Zum Eingang des Leitungstreibers 54 führt eine Verbindung 66, die eine Verzweigung V2 enthält. Eine Verbindung 76 führt zum Eingang des Leitungstreibers 56.

Von der Verzweigung V1 führt eine elektrisch leitfähige Verbindung 80 zu einem Eingang der Auswerteeinheit 58. Die Verbindung 80 dient zum Übertragen einer Messspannung Um, die gegen Masse M gemessen wird.

Der Leitungstreiber 54 enthält zur Strommessung einen Messwiderstand 81, über den mit Hilfe von zwei Messverbindungen 82, 84 eine Messspannung abgegriffen wird, die über den bekannten Widerstandswert R des Messwiderstandes 81 in einen Messstrom Im umgerechnet wird. Der Messwiderstand 81 wird sowohl für die im Folgenden erläuterte Erfassung des Zustandes des PTC-Widerstands 50 als auch für andere Mess- und Prüfzwecke verwendet.

Eine Verbindung 86 führt von einem Ausgang der Steuereinheit 60 zu der Verzweigung V2. Die Verbindung 86 dient zur Vorgabe von Spannungen im Rahmen der folgenden erläuterten Erfassung des differentiellen Widerstandes des PTC-Widerstandes 50. Eine Verbindung 88 dient zur Ausgabe eines Ergebnissignals oder eines Ergebnisdatums durch die Auswerteeinheit 58. Die Verbindungen 61 bis 88 sind bspw. Leitbahnen auf einer Leiterplatte.

Bei der an Hand der Figur 1 gezeigten Schaltungsanordnung gibt es an die Verbindung 64 bzw. 74 geschaltete Thyristoren, die gegen Masse geschaltet sind. Der Steuereingang der Thyristoren ist über jeweils eine Diode entweder mit der positiven Betriebsspannung oder mit einer negativen Betriebsspannung verbunden. Bei anderen Ausführungsbeispielen wird die Strommessung beispielsweise zwischen der Fremdspannungsquelle und dem PTC-Widerstand 50 in der Anschlussschaltung 14 durchgeführt.

Eine Spannung Ur liegt über dem PTC-Widerstand 50. Das Telefon 18 stellt die Last dar, die von der von den Leitungstreibern 54, 56 ausgegebenen Differenzspannung Udiff getrieben wird. Die Spannung des Gleichtaktanteils am Ausgang der Leitungstreiber 54 bzw. 56 gegen Masse M ist für den Normalbetrieb an der Last unerheblich. Der genaue Wert dieser Spannung kann unbekannt sein, beispielsweise wenn der Leitungstreiber 54, 56 an einer Spannungsversorgung betrieben wird, deren Spannung abhängig von der angeschlossenen Last erheblichen Schwankungen ausgesetzt ist. Bei einer batteriegestützten Versorgung kommt noch eine Zeitabhängigkeit aufgrund der kontinuierlichen Entladung der Batterie hinzu.

Für den Leitungstreiber 54 gilt die folgende Spannungsgleichung:

$$Utr = U(Gleich) + Udiff/2,$$

wobei U(Gleich) die Spannung des Gleichtaktanteils des Leitungstreibers 54 gemessen gegen Masse M ist.

Für den Leitungstreiber 56 gilt in einer Gegentaktendstufe dagegen die Spannungsgleichung:

$$Utr = U(Gleich) - Udiff/2.$$

Für die in Figur 1 dargestellte Anschlussschaltung 14 ergibt sich für den ohmschen Widerstand des PTC-Widerstands 50 die folgende Gleichung:

$$R(PTC) = (Um - Utr)/I.$$

Es ergibt sich mit der oben angegebenen Spannungsgleichung für die Spannung Utr des Leitungstreibers 54:

$$R(PTC) = (Um - U(Gleich) - Udiff/2)/I.$$

Damit lässt sich der ohmsche Widerstand R(PTC) des Widerstandes 50 nicht ermitteln, wenn die Spannung U(Gleich) nicht bekannt ist. Jedoch lässt sich der differentielle ohmsche Widerstand des PTC-Widerstandes 50 ermitteln, wenn mit Hilfe des Leitungstreibers 54 zwei verschiedene Spannungen ausgegeben werden, zu denen zwei verschiedene Spannung und zwei verschiedene Ströme gemessen werden. Der differentielle Widerstand Rdiff(PTC) ergibt sich aus dem Differenzenquotienten der beiden Spannungen und der beiden Ströme:

$$Rdiff(PTC) = \Delta U/\Delta I = (U1 - U2)/(I1 - I2).$$

Im Ausführungsbeispiel wird die Spannung U1 größer als die Spannung U2 gewählt. Für die Spannung U1 über dem PTC-Widerstand 50 bei der ersten Messung gilt:

$$U1 = Um1 - Utr1.$$

Für die Spannung U2 über dem PTC-Widerstand 50 gilt bei der zweiten Messung:

$$U2 = Um2 - Utr2.$$

Mit der oben angegebenen Formel für den differentiellen Widerstand Rdiff(PTC) gilt:

$$Rdiff(PTC) = (Um1 - Utr1 - Um2 + Utr2)/(I1 - I2),$$

wobei 11 der bei der ersten Messung erfasste Stromfluss und 12 der bei der zweiten Messung erfasste Stromfluss des Stroms I ist, d.h. des durch den Widerstand 50 fließenden Stroms.

Durch Einsetzen der oben angegebenen Gleichung für Utr ergibt sich:

$$Rdiff(PTC) = (Um1 - Um2 - Udiff1/2 + Udiff2/2)/(I1 - I2).$$

Dieses Ergebnis ist unabhängig von der Spannung U(Gleich). Die Spannungen Udiffl und Udiff2 sind bekannt, weil mit Hilfe der Steuereinheit 60 entsprechende Eingangsspannungen an die Eingänge der Leitungstreiber 54, 56 gelegt werden. Beispielsweise beträgt die Spannungsverstärkung A der Gegentaktendstufe mit den Leitungstreibern 54 und 56 gleich 60. In diesem Fall wird zum Erzeugen einer Differenzspannung Udiff1 von beispielsweise -10 Volt eine Spannungsdifferenz von -0,166 Volt an den Eingängen der Leitungstreiber 54, 56 angelegt. Zum Erzeugen einer Spannung Udiff2 für die zweite Messung von beispielsweise +10 Volt wird eine Spannung von +0,166 Volt als Differenz zwischen den Eingängen der Leitungstreiber 54, 56 angelegt. Damit ist das Ergebnis für Rdiff(PTC) unabhängig von der Spannung U(Gleich) und auch unabhängig von den Spannungen Utr.

Bei einem anderen Ausführungsbeispiel wird der differentielle Widerstand Rdiff(PTC) nach dem eben ermittelten Verfahren auch für eine Teilnehmerschaltungen durchgeführt, bei der keine Gegentaktstufe sondern eine einfache Endverstärkerstufe eingesetzt wird, so dass der Leitungstreiber 56 fehlt, siehe gestrichelte Darstellung in Figur 1.

Bei einem weiteren Ausführungsbeispiel wird nur das Vorzeichen von Rdiff(PTC) ermittelt, wobei keine Messspannung Um erfasst werden muss. Dies ist möglich, weil der Widerstand R(PTC) üblicherweise wesentlich größer als der Innenwiderstand Ri der Fremdspannungsquelle ist, beispielsweise um mindestens den Faktor 10 oder mindestens um den Faktor 100. Dies ist so, weil der PTC-Widerstand 50 nur bei einem hohen Strom und damit bei einem niedrigen Wert von Ri hochohmig wird. Bei diesem Ausführungsbeispiel wird die Spannung Udiff beispielsweise in positiver Richtung verändert. Dadurch ändert sich die Spannung über dem PTC-Widerstand 50 in negativer Richtung. Ist der PTC-Widerstand 50 niederohmig, so ändert sich der Strom auch in negativer Richtung. Ist der PTC-Widerstand 50 dagegen hochohmig, so ändert sich der Strom in positiver Richtung wegen des negativen differentiellen Widerstandes des PTC-Widerstandes 50.

Bei weiteren Ausführungsbeispielen mit Erfassung der Messspannung Um bzw. ohne Erfassen der Messspannung Um wird keine Spannung Udiff1 vorgegeben, so dass der Wert der Spannung Udiff1 gleich 0 Volt beträgt.

Figur 2 zeigt in einem Koordinatensystem 89 die Kennlinie des PTC-Widerstandes 50 im thermischen Gleichgewicht. Auf einer x-Achse 90 des Koordinatensystems 89 ist die Spannung Ur über dem PTC-Widerstand 50 aufgetragen, beispielsweise in einem Bereich von -150 Volt bis +150 Volt. Auf einer y-Achse 92 des Koordinatensystems 89 ist der Strom I durch den PTC-Widerstand 50 dargestellt, beispielsweise in einem Bereich von -100 Milliampere bis +100 Milliampere. Eine Kennlinie 94 des PTC-Widerstandes hat den folgenden Verlauf:

- in einem Spannungsbereich B1 von -150 Volt bis beispielsweise -10 Volt hat der Strom I ein negatives Vorzeichen und steigt betragsmäßig mit abnehmender Spannung erst langsam und dann schneller an,
- in einem Spannungsbereich B2 von beispielsweise -10 Volt bis +10 Volt steigt der Strom I dagegen linear mit zunehmender Spannung U an,
- in einem Bereich B3 von beispielsweise +10 Volt bis +150 Volt fällt der Strom I von einem hohen Stromwert (sogenannter Kippstrom) mit zunehmender Spannung U auf einen niedrigen positiven Stromwert, wobei das Abfallen erst schnell und dann immer langsamer ist.

Figur 3 zeigt Verfahrensschritte, die zum Bestimmen des Zustandes des PTC-Widerstandes 50 durchgeführt werden. Das Verfahren beginnt in einem Verfahrensschritt 100.

Zeitlich nach dem Verfahrensschritt 100 wird in einem Verfahrensschritt 102 durch die Steuereinheit am Eingang des Leitungstreibers 54 eine Spannung Ue1 angelegt, um die erforderliche Spannung Udiff1 zu erzeugen. In einem folgenden Verfahrensschritt 104 wird mit Hilfe der Auswerteeinheit 58 die Spannung Um1 und der Strom Im1 erfasst.

In einem folgenden Verfahrensschritt 106 wird mit Hilfe der Steuereinheit 60 eine Spannung Ue2 am Eingang des Leitungstreibers 54 angelegt, um die Spannung Udiff2 zu erzeugen. Bei noch anliegender Spannung Ue2 wird mit Hilfe der Auswerteeinheit 58 die Messspannung Um2 und der Messstrom Im2 erfasst.

In einem Verfahrensschritt 110 wird anschließend durch die Auswerteeinheit 58 das Vorzeichen des differentiellen Widerstandes Rdiff(PTC) nach den oben angegebenen Formeln ermittelt. In einem Verfahrensschritt 112 wird durch die Auswerteeinheit 58 festgestellt, ob das Vorzeichen positiv ist. Ist dies der Fall, so wird in einem dem Verfahrensschritt 112 unmittelbar folgenden Verfahrensschritt 114 vermerkt, dass sich der PTC-Widerstand 50 in dem linearen Bereich B2, d.h. in dem niederohmigen Bereich befindet. Beispielsweise wird ein Datum abgespeichert, das den Wert 0 hat. Alternativ wird auf der Ausgangsleitung 88 der Auswerteeinheit 58 ein Signal mit einem kleinen Spannungswert ausgegeben, bspw. 0 Volt.

Wird dagegen im Verfahrensschritt 112 festgestellt, dass das Vorzeichen negativ ist, so folgt unmittelbar nach dem Verfahrensschritt 112 ein Verfahrensschritt 116, in welchem vermerkt wird, dass sich der PTC-Widerstand in dem Bereich B3 befindet, d.h. in dem hochohmigen Bereich. Beispielsweise wird ein Datum mit dem Wert 1 gespeichert oder auf der Ausgangsleitung 88 wird ein Signal mit einem hohen Spannungswert ausgegeben, z.B. dem Spannungswert 5 Volt.

Sowohl nach dem Verfahrensschritt 114 als auch nach dem Verfahrensschritt 116 folgt ein Verfahrensschritt 118, in dem weitere Messungen an der Zweidrahtleitung bzw. am Telefon 18 des Teilnehmers TlnA von der Anschlussschaltung 14 aus durchgeführt werden. Dabei wird der im Verfahrensschritt 114 bzw. im Verfahrensschritt 116 gespeicherte Wert berücksichtigt. Nach dem Durchführen der Messungen wird das Verfahren in einem Verfahrensschritt 120 beendet. Alternativ werden die weiteren Messungen auch vor dem Ermitteln des differentiellen Widerstands bzw. vor dem Ermitteln des Vorzeichens des differentiellen Widerstands durchgeführt.

Bei einem alternativen Ausführungsbeispiel wird im Verfahrensschritt 110 außerdem der Wert des differentiellen Widerstandes Rdiff(PTC) mit Hilfe der oben angegebenen Formel ermittelt. In diesem Fall wird in den Verfahrensschritten 114 und 116 zusätzlich der ermittelte Wert des differentiellen Widerstands Rdiff(PTC) gespeichert.

Das Vorzeichen von Rdiff(PTC) wird bei einem anderen Ausführungsbeispiel ohne Erfassen der Messspannungen Um1 bzw. Um2 nach dem oben angegebenen Verfahren ermittelt.

Bei alternativen Ausführungsbeispielen wird nicht die Spannung durch den PTC-Widerstand 50 verändert, sondern der durch diesen PTC-Widerstand 50 fließende Strom.

Die Erfindung lässt sich beispielsweise bei Vermittlungsstellen eines durchschaltevermittelten Telekommunikationsnetzes einsetzen, beispielsweise in einer Vermittlungsstelle der Firma Siemens AG vom Typ EWSD (Elektronisches WählSystem Digital). Insbesondere in Sprach- und IVD-Baugruppen (Integrated Voice over Data, d.h. die gleichzeitige Übertragung von analogen Sprachsignalen und digitalen Daten über eine Leitung) werden Leitungsmessungen von den Anschlussports selber durchgeführt, so dass kein zusätzliches Equipment mehr notwendig ist. Andere Anwendungsbeispiele sind Baugruppen der Firma Siemens AG des Typs FastLink oder des Typs HiX.

## Patentansprüche

1. Schaltungsanordnung (10) zum Erfassen des Zustandes eines Schaltungs-Schutzelementes (50),
   mit einem Schutzelement (50), dessen Widerstand von der Spannung am Schutzelement (50) derart abhängt, dass sich in einem Spannungsbereich (B2) Stromfluss und Spannung zueinander gleichläufig ändern und dass sich in einem anderen Spannungsbereich (B1, B3) Stromfluss und Spannung zueinander gegenläufig ändern,
   mit mindestens einer Erfassungseinheit (80, 82, 84), die mindestens ein Potential oder eine Spannung am Schutzelement (50) oder die einen durch das Schutzelement (50) fließenden Strom erfasst,
   mit mindestens einer Vorgabeeinheit (60, 86), die mindestens eine Potentialänderung oder Spannungsänderung am Schutzelement (50) oder die eine Änderung des Stroms durch das Schutzelement (50) durchführt,
   und mit einer Auswerteeinheit (58), die eingangsseitig mit einem Ausgang der Erfassungseinheit (80, 82, 84) verbunden ist und die abhängig von einem Ausgangssignal oder Ausgangsdatum der Erfassungseinheit (80) und abhängig von mindestens einer mit der Vorgabeeinheit (60, 86) veranlassten Änderung ein Ausgangssignal oder ein Ausgangsdatum erzeugt, das eine Gleichläufigkeit oder eine Gegenläufigkeit von Spannung und Strom am Schutzelement (50) angibt.

2. Schaltungsanordnung (10) nach Anspruch 1, **gekennzeichnet durch** eine Leitung oder **durch** eine Anschlusseinheit (28, 30) für eine Leitung, die eine Länge von mehr als 50 Meter und von mehr als 500 Meter hat, insbesondere eine Leitung, an die auch ein Teilnehmerendgerät (18) eines Telekommunikationsnetzes angeschlossen ist.

3. Schaltungsanordnung (10) nach Anspruch 1 oder 2, **dadurch gekennzeichnet, dass** die Erfassungseinheit (81, 82, 84) einen Leitungstreiber (54) oder einen Teil eines Leitungstreibers (54) enthält, der eine Spannungsverstärkung für eine Leitung durchführt, insbesondere ein Leitungstreiber (54, 56), der gemäß Gegentaktprinzip arbeitet.

4. Schaltungsanordnung (10) nach einem der vorhergehenden Ansprüche, **dadurch gekennzeichnet, dass** die Vorgabeeinheit (60, 86) einen Leitungstreiber (54) oder einen Teil eines Leitungstreibers (54) enthält, der eine Spannungsverstärkung für eine Leitung durchführt, insbesondere ein Leitungstreiber (54, 56), der gemäß Gegentaktprinzip arbeitet.

5. Schaltungsanordnung (10) nach einem der vorhergehenden Ansprüche, **dadurch gekennzeichnet, dass** die Vorgabeeinheit (60, 86) mindestens zwei Änderungen für eine Erfassung durchführt.

6. Schaltungsanordnung (10) nach einem der vorhergehenden Ansprüche, **dadurch gekennzeichnet, dass** die Erfassungseinheit eine Spannungserfassungseinheit (80) enthält, die ein Potential oder eine Spannung an dem Schutzelement (50) erfasst, dass die Erfassungseinheit eine Stromerfassungseinheit (81, 82, 84) enthält, die einen durch das Schutzelement (50) fließenden Strom (I) erfasst,
   dass die Vorgabeeinheit eine Spannungsvorgabeeinheit (60, 86) ist oder enthält, die mindestens eine Spannung oder ein Potential vorgibt, das zu einer Potentialänderung am Schutzelement (50) führt,
   und dass die Auswerteeinheit (56) eingangsseitig mit einem Ausgang der Spannungserfassungseinheit (80) und mit einem Ausgang der Stromerfassungseinheit (82, 84) verbunden ist, und dass die Auswerteeinheit (56) abhängig von einem Ausgangssignal oder einem Ausgangsdatum der Spannungserfassungseinheit (80) und abhängig von einem Ausgangssignal oder einem Ausgangsdatum der Stromerfassungseinheit (82, 84) bei zwei verschiedenen Spannungen oder Potentialen am Schutzelement (50) ein Ausgangssignal oder Ausgangsdatum erzeugt, das nur das Vorzeichen des differentiellen Widerstandes (Rdiff) des Schutzelementes (50) oder das sowohl das Vorzeichen als auch den Betrag des differentiellen Widerstandes (Rdiff) angibt.

7. Schaltungsanordnung (10) nach einem der vorhergehenden Ansprüche, **dadurch gekennzeichnet, dass** die Spannungserfassungseinheit (80) die Spannung an einem Anschluss des Schutzelementes (50) gegen Masse erfasst.

8. Schaltungsanordnung (10) nach einem der vorhergehenden Ansprüche, **dadurch gekennzeichnet, dass** das Schutzelement (50) ein PTC-Widerstand oder ein Sicherungselement ist, das ein mit Kohlenstoff gefülltes Polymer enthält.

9. Schaltungsanordnung (10) nach einem der vorhergehenden Ansprüche, **gekennzeichnet durch** eine Steuereinheit (60), die ausgangsseitig mit der Vorgabeeinheit (86) und der Auswerteeinheit (58) verbunden ist.

10. Verfahren zum Erfassen des Zustandes eines Schutzelementes (50), insbesondere mit einer Schaltungsanordnung (10) nach einem der vorhergehenden Ansprüche,
   mit den Schritten:

   Erfassen eines durch das Schutzelement (50) fließenden ersten Stroms bei einer ersten Spannung am Schutzelement (50),
   Verändern der Spannung am Schutzelement (50) in einer vorgegebenen Richtung (106),
   Erfassen eines durch das Schutzelement (50) fließenden zweiten Stroms bei der veränderten Spannung (108),
   Ermitteln der Richtung, in der sich der Strom nach dem Verändern der Spannung verändert hat, aus dem ersten erfassten Strom und dem zweiten erfassten Strom (110).

11. Verfahren zum Erfassen des Zustandes eines Schutzelementes (50), insbesondere mit einer Schaltungsanordnung (10) nach einem der Ansprüche 1 bis 9,
   mit den Schritten:

   Erfassen einer ersten Spannung an dem Schutzelement (50) bei einem ersten Strom durch das Schutzelement (50),
   Verändern des Stroms durch das Schutzelement (50) in einer vorgegebenen Richtung,
   Erfassen einer zweiten Spannung an dem Schutzelement (50) bei dem veränderten Strom,
   Ermitteln der Richtung, in der sich die Spannung nach dem Verändern des Stroms verändert hat, aus der ersten erfassten Spannung und aus der zweiten erfassten Spannung.

12. Verfahren nach Anspruch 11 oder 12, **gekennzeichnet durch** den Schritt:

   automatisches Erzeugen eines Signals oder Datums (112 bis 116), das die Richtung der Stromänderung oder der Spannungsänderung angibt.

## Claims

1. Circuit arrangement (10) for sensing the state of a circuit protection element (50),
   having a protection element (50), the resistance of which is dependent on the voltage on the protection element (50) such that in one voltage range (B2) current flow and voltage change in the same direction as one another and that in another voltage range (B1, B3) current flow and voltage change in the opposite direction from one another,
   having at least one sensing unit (80, 82, 84) that senses at least one potential or a voltage on the protection element (50) or that senses a current flowing through the protection element (50),
   having at least one stipulation unit (60, 86) that makes at least one potential change or voltage change on the protection element (50) or that makes a change to the current through the protection element (50),
   and having an evaluation unit (58) that has its input side connected to an output of the sensing unit (80, 82, 84) and that, depending on an output signal or output data item from the sensing unit (80) and depending on at least one change prompted by means of the stipulation unit (60, 86), produces an output signal or an output data item that indicates that the voltage and the current on the protection element (50) are in the same direction or in opposite directions.

2.  Circuit arrangement (10) according to Claim 1, **characterized by** a line or by a connection unit (28, 30) for a line that has a length of more than 50 metres and of more than 500 metres, particularly a line to which a subscriber terminal (18) in a telecommunication network is also connected.

3.  Circuit arrangement (10) according to Claim 1 or 2, **characterized in that** the sensing unit (81, 82, 84) contains a line driver (54) or a portion of a line driver (54) that carries out voltage amplification for a line, particularly a line driver (54, 56) that operates on the basis of the push-pull principle.

4.  Circuit arrangement (10) according to one of the preceding claims, **characterized in that** the stipulation unit (60, 86) contains a line driver (54) or a portion of a line driver (54) that carries out voltage amplification for a line, particularly a line driver (54, 56) that operates on the basis of the push-pull principle.

5.  Circuit arrangement (10) according to one of the preceding claims, **characterized in that** the stipulation unit (60, 86) makes at least two changes for a sensing operation.

6.  Circuit arrangement (10) according to one of the preceding claims, **characterized in that** the sensing unit contains a voltage sensing unit (80) that senses a potential or a voltage on the protection element (50),
    **in that** the sensing unit contains a current sensing unit (81, 82, 84) that senses a current (I) flowing through the protection element (50),
    **in that** the stipulation unit is or contains a voltage stipulation unit (60, 86) that stipulates at least one voltage or a potential that results in a potential change on the protection element (50),
    and **in that** the evaluation unit (56) has its input side connected to an output of the voltage sensing unit (80) and to an output of the current sensing unit (82, 84),
    and **in that** the evaluation unit (56), depending on an output signal or an output data item from the voltage sensing unit (80) and depending on an output signal or an output data item from the current sensing unit (82, 84), for two different voltages or potentials on the protection element (50), produces an output signal or output data item that indicates only the arithmetic sign of the differential resistance (Rdiff) of the protection element (50) or that indicates both the arithmetic sign and the absolute value of the differential resistance (Rdiff).

7.  Circuit arrangement (10) according to one of the preceding claims, **characterized in that** the voltage sensing unit (80) senses the voltage on a connection of the protection element (50) with respect to earth.

8.  Circuit arrangement (10) according to one of the preceding claims, **characterized in that** the protection element (50) is a PTC resistor or a fuse element that contains a carbon-filled polymer.

9.  Circuit arrangement (10) according to one of the preceding claims, **characterized by** a control unit (60) that has its output side connected to the stipulation unit (86) and to the evaluation unit (58).

10. Method for sensing the state of a protection element (50), particularly with a circuit arrangement (10) according to one of the preceding claims,
    having the following steps:

    a first current flowing through the protection element (50) is sensed for a first voltage on the protection element (50),
    the voltage on the protection element (50) is altered in a stipulated direction (106),
    a second current flowing through the protection element (50) is sensed for the altered voltage (108),
    the direction in which the current has altered following the alteration of the voltage is ascertained from the first sensed current and the second sensed current (110).

11. Method for sensing the state of a protection element (50), particularly with a circuit arrangement (10) according to one of Claims 1 to 9,
    having the following steps:

    a first voltage on the protection element (50) is sensed for a first current through the protection element (50),
    the current through the protection element (50) is altered in a stipulated direction,

a second voltage on the protection element (50) is sensed for the altered current,
the direction in which the voltage has altered following the alteration of the current is ascertained from the first sensed voltage and from the second sensed voltage.

**12.** Method according to Claim 11 or 12, **characterized by** the following step:

a signal or data item (112 to 116) that indicates the direction of the current change or the voltage change is automatically produced.

**Revendications**

**1.** Circuit (10) pour détecter l'état d'un élément de protection de circuit (50) avec:

- un élément de protection (50) dont la résistance dépend de la tension au niveau de l'élément de protection (50) en ce sens que le flux de courant et la tension se modifient dans le même sens l'un par rapport à l'autre dans une plage de tension (B2) et que, dans une autre plage de tension (B1, B3), le flux de courant et la tension se modifient en sens opposé l'un par rapport à l'autre ;
- au moins une unité de détection (80, 82, 84) qui détecte au moins un potentiel ou une tension au niveau de l'élément de protection (50) ou un courant qui traverse l'élément de protection (50) ;
- au moins une unité d'exécution (60, 86) qui effectue au moins une modification de potentiel ou une modification de tension au niveau de l'élément de protection (50) ou une modification du courant qui traverse l'élément de protection (50) ; et
- une unité d'évaluation (58) qui est reliée à une sortie de l'unité de détection (80, 82, 84) côté entrée et qui génère, en fonction d'un signal de sortie ou d'une donnée de sortie de l'unité de détection (80) et en fonction d'au moins une modification provoquée par l'unité d'exécution (60, 86), un signal de sortie ou une donnée de sortie indiquant le même sens ou le sens opposé de la tension et du courant au niveau de l'élément de protection (50).

**2.** Circuit (10) selon la revendication 1, **caractérisé par** une ligne ou une unité de connexion (28, 30) pour une ligne d'une longueur supérieure à 50 mètres et supérieure à 500 mètres, et plus particulièrement une ligne à laquelle est également connecté un terminal d'abonné (18) d'un réseau de télécommunications.

**3.** Circuit (10) selon la revendication 1 ou 2, **caractérisé en ce que** l'unité de détection (81, 82, 84) contient un pilote de ligne (54) ou une partie d'un pilote de ligne (54) qui effectue une amplification de tension pour une ligne, et plus particulièrement un pilote de ligne (54, 56) qui fonctionne selon le principe push pull.

**4.** Circuit (10) selon l'une des revendications précédentes, **caractérisé en ce que** l'unité d'exécution (60, 86) contient un pilote de ligne (54) ou une partie d'un pilote de ligne (54) qui effectue une amplification de tension pour une ligne, et plus particulièrement un pilote de ligne (54, 56) qui fonctionne selon le principe push pull.

**5.** Circuit (10) selon l'une des revendications précédentes, **caractérisé en ce que** l'unité d'exécution (60, 86) effectue au moins deux modifications pour une détection.

**6.** Circuit (10) selon l'une des revendications précédentes, **caractérisé en ce que** .

- l'unité de détection contient une unité de détection de tension (80) qui détecte un potentiel ou une tension au niveau de l'élément de protection (50) ;
- l'unité de détection contient une unité de détection de courant (81, 82, 84) qui détecte un courant (I) qui traverse l'élément de protection (50) ;
- l'unité d'exécution est ou contient une unité d'exécution de la tension (60, 86) qui spécifie au moins une tension ou un potentiel entraînant une modification de potentiel au niveau de l'élément de protection (50) ; et
- l'unité d'évaluation (56) est reliée, côté entrée, à une sortie de l'unité de détection de tension (80) et à une sortie de l'unité de détection de courant (82, 84) ; et
- l'unité d'évaluation (56) génère, en fonction d'un signal de sortie ou d'une donnée de sortie de l'unité de détection de tension (80) et en fonction d'un signal de sortie ou d'une donnée de sortie de l'unité de détection de courant (82, 84), pour deux tensions ou potentiels différents au niveau de l'élément de protection (50), un signal de sortie ou une donnée de sortie indiquant uniquement le signe de la résistance différentielle (Rdiff) de l'élément de protection (50) ou non seulement le signe, mais aussi la valeur absolue de la résistance différentielle (Rdiff).

7. Circuit (10) selon l'une des revendications précédentes, **caractérisé en ce que** l'unité de détection de tension (80) détecte la tension au niveau d'une connexion de l'élément de protection (50) à la masse.

8. Circuit (10) selon l'une des revendications précédentes, **caractérisé en ce que** l'élément de protection (50) est une résistance PTC ou un élément de sécurité qui contient un polymère rempli de carbone.

9. Circuit (10) selon l'une des revendications précédentes, **caractérisé par** une unité de commande (60) qui est reliée, côté sortie, à l'unité d'exécution (86) et à l'unité d'évaluation (58).

10. Procédé de détection de l'état d'un élément de protection (50), en particulier au moyen d'un circuit (10) selon l'une des revendications précédentes, comportant les étapes suivantes .

    - détection d'un premier courant traversant l'élément de protection (50) pour une première tension au niveau de l'élément de protection (50) ;
    - modification de la tension au niveau de l'élément de protection (50) dans un sens prédéfini (106) ;
    - détection d'un deuxième courant traversant l'élément de protection (50), la tension étant modifiée (108) ;
    - détermination du sens dans lequel le courant s'est modifié, après la modification de la tension, à partir du premier courant détecté et du deuxième courant détecté (110).

11. Procédé de détection de l'état d'un élément de protection (50), en particulier au moyen d'un circuit (10) selon l'une des revendications 1 à 9, comportant les étapes suivantes :

    - détection d'une première tension au niveau de l'élément de protection (50) pour un premier courant traversant l'élément de protection (50) ;
    - modification du courant traversant l'élément de protection (50) dans un sens prédéfini ;
    - détection d'une deuxième tension au niveau de l'élément de protection (50), le courant étant modifié ;
    - détermination du sens dans lequel la tension s'est modifiée, après la modification du courant, à partir de la première tension détectée et à partir de la deuxième tension détectée.

12. Procédé selon la revendication 11 ou 12, **caractérisé par** l'étape suivante :

    - génération automatique d'un signal ou d'une donnée (112 à 116) indiquant le sens de la modification du courant ou de la modification de la tension.

# FIG 1

Tln A

Auswerteeinheit
Steuereinheit

Um, Im, M, 58, 88, 60, 86, V2, 66, 84, 54, 81, 82, 80, Ur, 50, R, 64, Utr, Udiff, 52, 74, 56, 76, 62, V1, 61, 28 Um, M, 72, 24, 30, 26, I, 20, 22, Ri, Uf, 18, 10, 12, 14

# FIG 2

## FIG 3

```
        ┌─────────┐
        │  Start  │──── 100
        └────┬────┘
             │
             ▼
    ┌──────────────────┐
    │   Ue1 anlegen    │──── 102
    └────────┬─────────┘
             │
             ▼
    ┌──────────────────┐
    │     Um1 und      │──── 104
    │   Im1 erfassen   │
    └────────┬─────────┘
             │
             ▼
    ┌──────────────────┐
    │   Ue2 anlegen    │──── 106
    └────────┬─────────┘
             │
             ▼
    ┌──────────────────┐
    │     Um2 und      │──── 108
    │   Im2 erfassen   │
    └────────┬─────────┘
             │
             ▼
    ┌──────────────────┐
    │  Vorzeichen VZ und │
    │   ggf. Wert von    │──── 110
    │  Rdiff ermitteln   │
    └────────┬─────────┘
             │
             ▼
        ╱────────────────╲    Ja
       ⟨ VZ bzw. Rdiff>0  ⟩────────┐
        ╲────────────────╱         │
             │ Nein   112          │
             ▼                     ▼
    ┌──────────────────┐   ┌──────────────────┐
116─│   hochohmigen    │   │   lin. Bereich   │──── 114
    │ Bereich vermerken│   │    vermerken     │
    └────────┬─────────┘   └────────┬─────────┘
             │                      │
             │◄─────────────────────┘
             ▼
    ┌──────────────────┐
    │ weitere Messung  │──── 118
    └────────┬─────────┘
             │
             ▼
        ┌─────────┐
        │  Ende   │──── 120
        └─────────┘
```

**IN DER BESCHREIBUNG AUFGEFÜHRTE DOKUMENTE**

**In der Beschreibung aufgeführte Patentdokumente**

- DE 8913708 U1